Europäisches Patentamt

(19) European Patent Office

Office européen des brevets

(11) EP 0 871 200 A2

(12) EUROPEAN PATENT APPLICATION

(43) Date of publication:
14.10.1998 Bulletin 1998/42

(51) Int. Cl.$^6$: H01J 37/32

(21) Application number: 98300674.3

(22) Date of filing: 30.01.1998

(84) Designated Contracting States:
AT BE CH DE DK ES FI FR GB GR IE IT LI LU MC
NL PT SE
Designated Extension States:
AL LT LV MK RO SI

(30) Priority: 21.02.1997 US 804430

(71) Applicant:
Applied Materials, Inc.
Santa Clara, California 95054 (US)

(72) Inventors:
• Wu, Robert W.
Pleasanton, California 94566 (US)
• Shel, Viktor
Milpitas, California 95035 (US)
• Cui, Chunshi
Santa Clara, California 95051 (US)
• Yin, Gerald Zheyao
Cupertino, California 95014 (US)

(74) Representative:
Bayliss, Geoffrey Cyril et al
BOULT WADE TENNANT,
27 Furnival Street
London EC4A 1PQ (GB)

(54) **Low temperature etch process utilizing power splitting between electrodes in an RF plasma reactor**

(57) A low-temperature (<200°C) oxide etch process, particularly applicable to a bi-level contact structure, practiced in a high-density plasma etch reactor having both parallel electrodes (34,52) and an inductive coil (46) for coupling RF energy into the plasma. The top electrode (52) is composed of a fluorine scavenger, such as silicon, glass carbon, or silicon carbide. The RF bias power is split in a predetermined selectable ratio between the two electrodes. Up to 25% of the total RF power is applied to the scavenging electrode to achieve the desired selectivity with adequate margin against etch stop. The etch chemistry typically includes $C_2F_6$, CO, and Ar (or $C_4F_8$), and the entire chamber is kept below 180°C. Etching TEOS-grown oxide with the inventive method produces center-point process results of an oxide etch rate of greater than 800nm/min and a selectivity to polysilicon of greater than 50:1.

FIG._2

**Description**

The invention relates generally to plasma reactors and their operation. In particular, the invention relates to the plasma etching of semiconductors, and more particularly to oxide etching.

The level of integration in semiconductor integrated circuits continues to increase. The next generation of dynamic memories will have a capacity of 64 megabits and that of microprocessors will have upwards of ten million transistors. Further generations are being planned. These densities are obtainable only by the continuing shrinkage of feature sizes, now pushing towards 0.15µm. However, layer thicknesses cannot similarly shrink because of physical effects such as dielectric breakdown and resistive losses. Hence, current designs call for features with high aspect ratios, that is, the ratio of the depth of a feature to its width. For example, a via electrically connects two levels of metallization through an intervening dielectric layer. Since the dielectric layer is constrained to a moderately large thickness, a dense circuit retires very narrow vias, and the resulting aspect ratios are three and higher. Etching high aspect ratio holes requires a highly anisotropic etch.

A further problem is that for economic reasons, the size of wafers being processed is increasing. Most current high-production equipment is designed for 200mm wafers, and equipment is being designed for 300mm wafers. Such large wafers impose stringent uniformity requirements on the etching process.

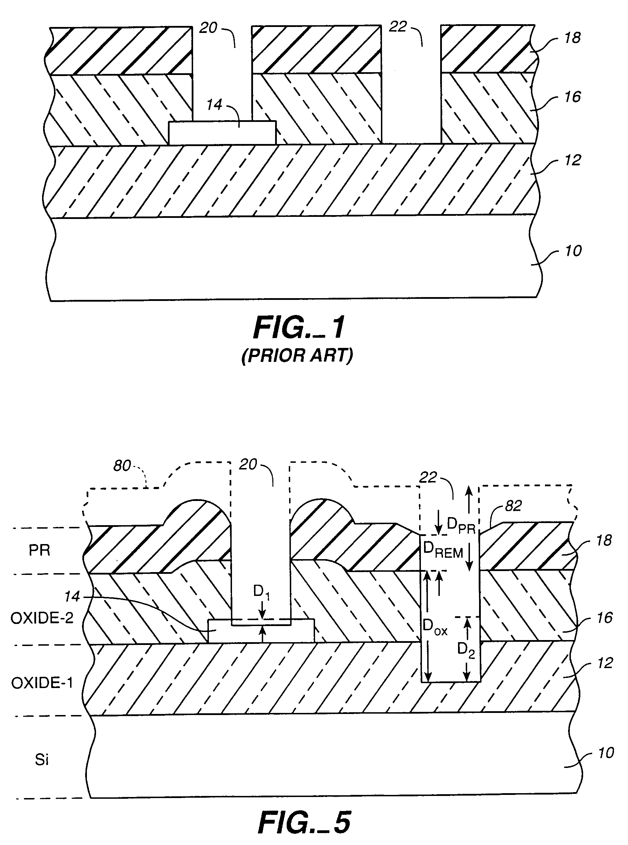

Some of the increased density is being achieved by more complex integrated circuit structures, which however impose additional requirements upon the processing, particularly in the etching. An example is the structure for a bilevel contact shown cross section in FIG. 1. A silicon substrate 10 includes unillustrated structure already formed therein that requires contacting from an upper level. A first oxide layer 12, for example, of plasma-deposited silicon dioxide, is deposited over the silicon substrate 10. A relatively thin polysilicon interconnect 14 is deposited and defined over the first oxide layer 12, and a second oxide layer 16 is deposited over both the interconnect 14 and the first oxide layer 10. Thereafter, a single photolithographic etching step using a single photomask etches both a relatively shallow via hole 18 and a deeper substrate contact hole 20. It is to be appreciated that a very similar process may be used where both of the holes are used to contact respective polysilicon interconnects on different levels.

The bilevel contact structure requires an etch process that is highly selective to silicon. That is, a process that selectively etches silicon oxide but etches silicon to a much less extent. If the selectivity is insufficiently high, the polysilicon interconnect 14 would be etched through while, under the same etching conditions, the thicker first oxide layer is being etched through.

Oxide etch selectivity has been achieved in a plasma reactor with a fluorocarbon etching gas and a fluorine scavenger. A fluorocarbon consists only of carbon and fluorine. Examples of fluorocarbon etching gases are $CF_4$, $C_2F_6$, $C_4F_8$. It is believed that under common conditions the fluorocarbon gas deposits a polymer on all surfaces. However, if the polymer has a sufficiently low fluorine content, oxygen in an underlying silica ($SiO_2$) layer reacts with the polymer to form volatile CO and $CO_2$. That is, the underlying silica prevents the polymer being formed, and the silica is etched. On the other hand, an underlying layer of silicon (or silicon nitride, $Si_3N_4$) does not contain oxygen, and the polymer deposits faster than it is etched to thereby protect the underlying silicon layer from being etched. As a result, etching of the via and contact holes 18, 20 proceed until silicon layers 14, 10 are reached, at which point etching stops or is substantially reduced.

The selectivity provided by the polymer depends, however, on the polymer having a relatively low fluorine content. Silicon is the most preferable of a number of materials known to scavenge fluorine from a fluorocarbon plasma. The silicon reacts with the fluorine radicals F* in the plasma, and any polymer resulting from the plasma then has a low fluorine content. Generally, however, the silicon requires some activation. Rice discloses thermal activation of the silicon in U.S. Patent 5,477,975. It has been recognized that alternatively the silicon can be activated with RF biasing of the silicon electrode, as has been disclosed by Collins et al. in U.S. Patent 5,556,501 and European Patent Publication 552,491-A1. The silicon electrode can be formed as a large piece of polysilicon. Alternative fluorine scavenging materials are glassy carbon and silicon carbide.

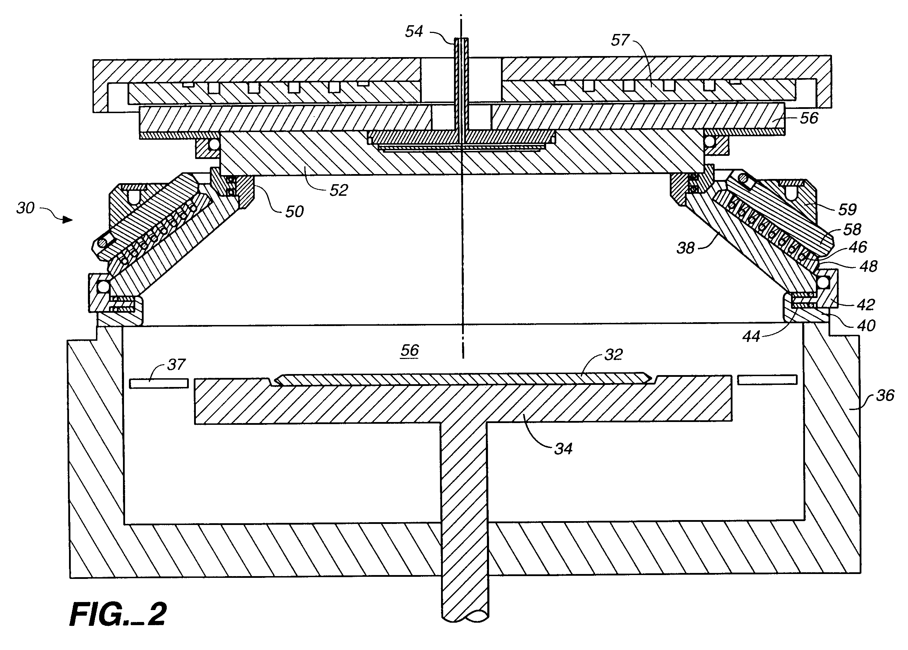

Schneider et al. in the parent patent application, incorporated herein by reference, address these many problems involved in oxide etching. Among several embodiments, they disclose the conically shaped plasma reactor 30 illustrated in cross section in FIG. 2. A wafer 32 is supported on a pedestal 34 that is preferably vertically movable with respect to a lower chamber body 36. A ring 37 surrounds the upper portion of the pedestal 34. In the examples described here, the ring 37 is composed of quartz and is left thermally floating. However, it is possible to form the ring 37 of silicon and use it as a thermally activated fluorine scavenger. The heating can rely upon the plasma heating, or the heating can be active, relying upon, for example, controlled radiant heating of the silicon ring 37. For control of lower chamber temperatures, the plasma heating needs to be compensated by cooling of the chamber parts.

An upper chamber assembly includes a conical dome 38 supported on the lower chamber body 36 through an electrical insulating joint including a plasma guard 40, a seal ring 42, and intervening support pads 44. Preferably, the conical dome is composed an electrically insulating bulk body of sintered silicon carbide and an electrically conductive inner film of chemical vapor deposited (CVD) silicon carbide or of high resistivity ($\rho > 20\Omega$-cm) polysilicon.. An RF inductive coil 46 supported in a coil carrier 48 is wrapped around the conical dome 38. The resistivities of the sintered and CVD silicon carbide portions of the conical dome 38 are chosen such that the RF magnetic field induced through the inductive coil 46 can pass through the dome 38 with minimal loss but the inner CVD film can be set to a predetermined electrical potential to provide a grounding plane.

An electrically insulating plasma guard 50 rests on the top inner rim of the conical dome 38 and in turn supports a roof 52 through an electrically insulating O-ring or Vespel spacer. A center gas feed 54 is integrated with the roof 52 and supplies processing gas into the reactor 30 through unillustrated holes in the roof 52. Most of the remaining illustrated structure is involved with the temperature control of the conical dome 38 and the roof 52 and is fully described in the parent application. The roof thermal control includes a resistively heated plate 56 and a water-cooled chiller plate 57. The dome thermal control includes a resistively heated conical sheath 58 and a water-cooled collar 59.

The diameter of the exposed portions of the roof 52 is approximately equal to the diameter of the pedestal. That is, the two electrodes sandwiching the plasma have the same size.

For an oxide etcher, the roof 52 is preferably formed of an electrically conductive fluorine scavenger, examples of which are polysilicon, silicon carbide, and glassy carbon. Typically, the etching gas is a fluorocarbon, and ethyl hexafluoride ($C_2H_6$) has been extensively tested in the illustrated reactor for oxide etching. When RF power, typically in the frequency range of 1 to 2MHz, is applied both to the coil 46 and across the two electrodes formed by the pedestal 34 and the roof 52, a fluorocarbon plasma is excited in the reactor 30, including a processing space 56 above the wafer 32. The fluorine scavenger is made to contact the plasma and to remove certain amounts of fluorine from the plasma. Thereby, any polymer formed on the wafer 32 from the fluorocarbon plasma is deficient in fluorine. As is now well know, a low-fluorine polymer can produce a highly selective etch to silicon, for example, in the bi-level contact structure of FIG. 1.

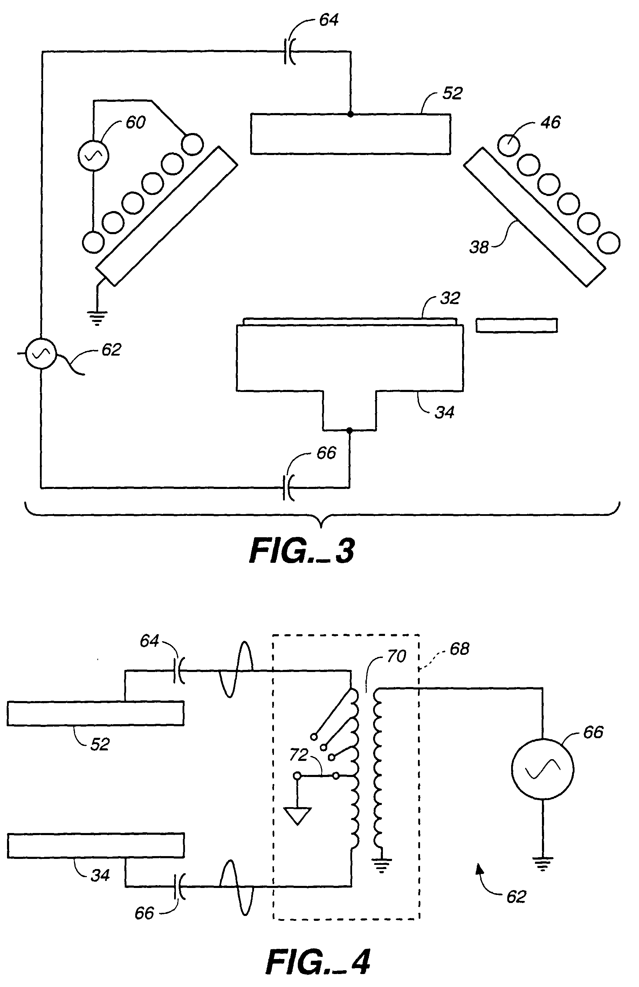

It is now known that one way to activate the fluorine scavenger is to apply RF energy to it. That is, the roof 52 is not merely grounded, but a significant RF signal is applied to it. Collins et al. disclose in U.S. Patent Application, Serial No. 08/734,797, filed October 23, 1996 that a sufficient amount of RF power should be applied to the roof 52 to promote removal from it of silicon for scavenging fluorine. As is shown in the parent patent application, the electrical circuit in this use is illustrated schematically in FIG. 3. The conical dome 38 is electrically grounded, and its surrounded coil 46 is powered by a first RF power supply 60. A power-splitting RF power supply 62 is coupled through two coupling capacitors 64, 66 to both the roof 52 and the pedestal 34. An example of a power-splitting RF power supply 62 is schematically illustrated in FIG. 4. A second RF power supply 66 supplies single-phase RF power to a power splitting circuit 68. For example, the RF power is applied to the primary of a wide-band transformer 70. The secondary of the transformer 72 has a number of taps, and a switch 72 selectively connects any one of these taps to a predetermined potential such as ground. Respective ends of the transformer secondary are connected through the coupling capacitors 64, 66 to the roof 52 and the pedestal 34. Dependent upon the setting of the transformer tap switch 72, varying amounts of RF power are split between the roof 52 and the pedestal 34. In the illustrated position at the midpoint of the transformer secondary (which is not a recommended position, as will be explained later) and assuming equal sizes for the roof 52 and the pedestal 34, equal amounts of RF power are delivered to the roof 52 and the pedestal. On the other hand, if a tap at the roof end of the transformer secondary is switched to ground, then the roof 52 is AC grounded and no RF power is delivered to the roof 52. This is the mode of operation that has been used by Rice et al. when the silicon-based fluorine scavenger is thermally activated. Tap positions between these two extremes split different ratios of power with a majority of power going to the pedestal 34.

A further consideration is the temperature required for the scavenging roof 52. It is known that elevated temperatures will activate the silicon roof 52. When conventional oxide etching processes were applied to the reactor of the Rice et al. patent, a satisfactory bi-level structure required the silicon roof and the quartz dome to be respectively heated up to 280°C and 220°C to achieve adequate selectivity to the underlying polysilicon and to the overlying photoresist without the occurrence of etch stop. However, vacuum seals such as O-rings present a substantial problem at these temperatures because they are preferably formed of an elastic polymeric material. At elevated temperatures, particularly in the etching ambient, polymeric O-rings quickly harden and lose their sealing abilities. Even with extra precautions to protect the O-rings from the fluorocarbon or hydrofluorocarbon plasma, they still need to be replaced at relatively frequent intervals if they are maintained at high temperatures. As a result, it is greatly desired to reduce the operating temperature of the walls of an etch reactor.

A further problem with relying upon thermal activation of the fluorine scavenger is that the temperature of the solid scavenger becomes a critical control parameter for achieving selectivity and other etching performance parameters. Due to processing and apparatus variability, thermal uniformity over time is often too poor to achieve the required performance uniformity. Thus, RF activation of the fluorine scavenger is preferred over thermal activation.

The invention can be summarized as an plasma process method, most particularly an oxide etching process, in a chamber having two opposed electrodes, one supporting the substrate being processed. Differing amounts of RF power are applied to the two electrodes, whereby the second electrode is chemically activated.

The invention is particularly applicable to an oxide or nitride etch process using a fluorine-based chemistry in a principally inductively coupled plasma reactor. The second electrode is formed of a fluorine-scavenging material, such as silicon, and may be in parallel opposition to the substrate-bearing electrode. The RF power applied to the scavenging electrode activates the scavenging species, thereby allowing a reduction in the temperature of the scavenger.

The following is a description of some specific embodiments of the invention, reference being made to the accompanying drawings, in which:

FIG. 1 is cross-sectional view of a bi-level contact structure in a semiconductor integrated circuit.
FIG. 2 is a cross-sectional view of a plasma etch chamber usable with the invention.
FIG. 3 is a schematic electrical circuit of the major RF components of the chamber of FIG. 2.
FIG. 4 is an electrical schematic of a power-splitting circuit.
FIG. 5 is a cross-sectional view of a test structure formed on a wafer and used in evaluating the invention.

We have found it advantageous to split the RF power capacitively coupled into the plasma reactor between the two RF electrodes, especially when the roof electrode overlying the wafer is composed of a scavenger for fluorine in a fluorine etch chemistry. If between about 10% and 35% of the RF power is coupled to the scavenging electrode roof and the larger remaining amount of the RF power is coupled into the pedestal holding the wafer, high selectivity is achieved at relatively low chamber temperatures without the occurrence of etch stop.

The control of fluorine is critical for the formation and maintenance of polymeric coatings in fluorine-based oxide and nitride etching. Marks et al., *ibid.*, recognized that the polymer should have a low fluorine content to achieve high selectivity to silicon. This can be accomplished by maintaining a low ratio of fluorine to carbon (F/C ratio) in the plasma. On the other hand, a high etching rate is promoted by a high F/C ratio. As noted above, fluorine can be removed from the plasma by a scavenging process. Even apart from the effect on etching rate, the scavenging must be controlled for the etching holes into oxide which have a high-aspect ratio.

Solid silicon is the scavenger of choice although carbon is also used and other materials can be used in a thermally activated process. For the solid silicon to scavenge fluorine, it must be activated, either thermally or by RF biasing or by a combination of the two. We have discovered that applying a small but finite portion of the RF biasing power to the silicon counter-electrode advantageously activates the silicon scavenging at a reasonably low temperature of the silicon and the associated chamber parts and seals. However, it is important for deep etching of narrow holes to limit the amount of RF biasing of the silicon scavenger lest excessive polymer form on the oxide being etched and stop the etching process. We also believe that the silicon scavenger should be heated to somewhat raised temperature so as to lower the RF activation energy of the scavenger and to thus provide more reproducible results.

Applying RF bias to the silicon counter electrode is similar to applying RF bias to a pedestal supporting the wafer, particularly in a principally inductively coupled plasma reactor. As is explained by Lieberman et al. in *Principles of Plasma Discharges and Materials Processing*, (Wiley, 1994), p. 309, an inductively coupled plasma reactor can produce a high-density plasma, but the plasma has relatively low sheath voltages. To increase the ion bombardment energy of ions extracted from the plasma, an RF bias may be capacitively coupled to the wafer. In the present invention, a similar concept is used to chemically activate the silicon-based fluorine scavenger.

In order to determine the effectiveness of the invention and establish general process windows, test chips were fabricated and etched to have the structure of FIG. 5. Both oxide layers 12, 16 were formed by a plasma TEOS process. The lower oxide layer 12 was made thick enough so that for a fixed etch period it was not etched through and the contact hole 22 did not extend down to the underlying silicon 10, as it would in a normal device. The upper oxide layer 16 was formed to a thickness of about 500nm. A photoresist 18 was deposited to a thickness of 700nm and patterned to form an etch mask having a critical lateral dimension of less than 500nm. The masked planar structure was then etched under a range of conditions to be specifically described below. After completion of etching, the test chips were sectioned to reveal the structure of FIG. 5, from which several important parameters can be deduced.

The oxide etch rate ER is measured by dividing the total oxide etch depth $D_{OX}$ in the contact hole 22 by the time of the etch. The polysilicon selectivity $S_{poly}$ is the ratio of the etch rate of silicon oxide to the etch rate of polysilicon. This can be directly measured from the micrographs by comparing the depth $D_1$ of etch of the polysilicon inter-level layer 14 at the bottom of the via hole 20 with the depth $D_2$ of oxide etching in the contact hole 22 that occurs after the polysilicon inter-level layer 14 has been reached. The top of the oxide depth $D_2$ is assumed to be aligned with the top of the polysilicon inter-level layer 14. The resolution on measuring the polysilicon etch depth $D_1$ was about 10nm.

The photoresist 18 also etches along with the oxide. Dotted line 80 shows the original top of the photoresist 18. However, the more important selectivity with respect to the photoresist accounts for the facets 82 that develop in the photoresist 18 just above the tops of the via and contact holes 20, 22. The original thickness of the photoresist is represented by $D_{PR}$, and the thickness of the photoresist 18 remaining below the facets 70 is represented by $D_{REM}$. The facet selectivity $S_{FACET}$ is the ratio of the oxide depth $D_{OX}$ to the loss of photoresist 18 at the bottom of the facets 82, that is,

$$S_{FACET} = \frac{D_{OX}}{D_{PR} - D_{REM}} \quad . \qquad (1)$$

In one set of experiments, a series of test chips were grown under similar conditions except for the amount of power splitting. Both the roof and the dome were maintained at around 220°C, the chamber pressure was held at 11.5mT. The processing gas flow consisted of 150sccm of Ar, 10sccm of $C_2F_6$, 20sccm of CO, and 50sccm of $CHF_3$. A source power of 2800W of RF was applied to the coil, and a bias power of 1400W was split between the pedestal and roof. The wafer temperature was held low by keeping He at a raised pressure on the backside of the wafer to convect heat to a chilled pedestal. The total etching time was 100s. The results are summarized in TABLE 1. The values for power splitting refer to the fraction of RF bias power applied to the roof, the remainder being applied to the pedestal. The roof 52 was formed of conductive polysilicon. The conical dome 38 was formed either of high-resistivity polysilicon or of a composite of bulk silicon carbide covered by a film of CVD silicon carbide. No quartz ring 37 was used. A zero value of power splitting means that the roof is grounded. For the set of experiments, the RF bias applied to the wafer was maintained constant.

TABLE 1

|  | Power Splitting | | |
|---|---|---|---|
|  | 0% | 10% | 25% |
| $D_{OX}$ (nm) | 840 | 803 | 600 ES |
| $S_{POLY}$ | 35 | 40 | >50 |
| $S_{FACET}$ | 3.1 | 2.9 | 3.0 |

The oxide etch depth, which is normally proportional to the oxide etch rate, is highest for a grounded roof, an unsurprising result since, if all bias power is applied to the pedestal, then the activity is strongest near the wafer. However, at 25% power splitting, etch stop is observed in the deep contact holes, which means that in the middle of the etching processing the oxide etching stopped. The polysilicon selectivity $S_{POLY}$ increased with increasing power splitting. The value of >50 for 25% power splitting means that there was no observable etching of the polysilicon inter-level layer. The values of facet selectivity $S_{FACET}$ were adequate in all cases. These data are believed to mean that increased power splitting intensifies the polymer chemistry since more RF power is applied to the silicon roof, which activates the silicon to scavenge fluorine from the plasma, thereby promoting the carbonaceous low-fluorine polymer. Since polymer on exposed silicon decreases or stops the silicon etching, the polysilicon selectivity $S_{POLY}$ benefits from the increased power splitting. However, polymer deposition is a balance between initial deposition and etch removal. On oxide surfaces, the removal is usually sufficiently high to prevent a significant accumulation. However, it is believed that for 25% power splitting, the polymer formation is so great that towards the bottom of the contact hole the etch removal falls behind. Thereafter, no more oxide is etched.

An additional set of experiments were performed with 50:50 power splitting. Consistent with the data presented above, with 50% of the RF power applied to the silicon electrode, etch stopping was observed to be a problem. Also, this high level of power splitting reduces the oxide etch rate. It is believed that this high value of power splitting produces too much power loss on the substrate Further, the high amount of RF power applied to the silicon roof means that it will be etched at about the same rate as any exposed silicon on the substrate, thus reducing its lifetime.

Ogle et al. in U.S. Patent 4,871,421 teach power splitter in a capacitively coupled plasma etcher for the purpose of reducing extraneous arcing and results in a well focused, stabilized plasma. Hence, Ogle et al. teach and claim 50% power splitting so that equal RF voltages are applied to both electrode. Ogle et al. are concerned neither with fluorine scavenging nor with chamber temperatures. It is believed that further increases in power splitting substantially beyond 25%, particularly to the 50% level of Ogle et al, would increase the polysilicon selectivity but at the price of worsening the etch stop. High selectivity is desirable, but not if it causes fatal etch stop. Ogle et al. based their invention on an earlier U.S. Patent 4,626,312. Dible discloses related effects in U.S. Patent 5,573,595.

The excessive activation of the silicon roof at 25% power splitting may be understood to imply that thermal activation may be reduced. That is, the temperature of the roof may be reduced while a good process is still obtained. A series of test chips were fabricated under identical condition similar to those of TABLE 1 except that the temperature was varied. The results are shown in TABLE 2 for etching at the wafer center.

TABLE 2

| | Power Splitting | | |
|---|---|---|---|
| | 25% | 25% | 0% |
| Roof Temperature | 220°C | 185°C | 180°C |
| Dome Temperature | 220°C | 185°C | 190°C |
| $D_{OX}$ (nm) | 600 ES | 800 | 720 |
| $S_{POLY}$ | >50 | >50 | 17 |
| $S_{FACET}$ | 3.0 | 3.1 | 2.5 |

As before, 25% power splitting at a roof temperature of 220°C caused etch stop. However, 25% power splitting at a roof temperature of 185°C produced a relatively high etch rate and superior polysilicon selectivity but without the occurrence of etch stop. For comparison, a grounded roof held at 180°C had a somewhat reduced etch rate and a relatively high but reduced polysilicon selectivity.

Thus is it seen that the chamber temperature can be kept at 220°C and lower to achieve a highly selective oxide etch. Indeed, the silicon roof can be kept below 200°C, thus greatly simplifying the O-ring aging problem.

An extra benefit of controlling the polymer chemistry and of reducing the temperature of the chamber walls is that less polymer is deposited on the chamber walls. Hence, they need not be so frequently cleaned.

The above examples used a processing gas of the fluorocarbon $C_2F_6$, the hydrofluorocarbon $CHF_3$, and carbon monoxide CO. Other processing gases have not yet been extensively explored with power splitting. The carbon monoxide is not thought to be crucial. The fluorocarbon $CF_4$ should benefit from the invention, and the use of a hydrofluorocarbon may not be required.

The processing window for the invention for any etching gas needs to be established by thorough experimentation. It is felt that power splitting ratios of between 5% and 35% will be useful with different etching gases. Scavenger temperatures need be no higher than 225°C, and can advantageously be kept below 200°C. The experiments show good etching characteristics for scavenger temperatures down to 180°C, and lower temperatures yet can be contemplated.

Although the examples were directed to the important case of etching oxides over silicon, it is well known that similar fluorine scavenging effects are obtained while etching nitride ($Si_3N_4$) and silicon oxynitrides ($Si_xN_yO_2$).

Although the examples advantageously used a plasma reactor in which the major portion of the plasma power was supplied inductively, power splitting can be also be applied to the more traditional capacitively coupled plasma reactors as well as to other types of high-density plasma reactors such as helicon source, ECR (electron-cyclotron resonance) source, and remote plasma sources. The conically shaped coil and dome are advantageous for the practice of the invention, but other forms of inductive coils may be employed. Also, it is to be appreciated that the scavenging electrode need not be a parallel counter electrode, but other scavenging surfaces may be placed into contact with the plasma and be RF biased to activate the scavenging. For example, the conical dome or a cylindrical sidewall may act as the scavenger.

Although silicon may be used as the fluorine scavenger, other solid materials have been proposed. Examples are silicon carbide and glassy carbon.

The invention provides a method of providing additional control of a plasma process, and this control can be implemented with only minor additions to existing equipment. With the use of capacitive activation of chamber parts, such as the fluorine scavenger, operating temperatures of the chamber can be significantly reduced, with an accompanying reduction in chamber cost and maintenance.

**Claims**

1. A process for etching a substrate, comprising:

supporting a substrate to be etched upon a pedestal electrode in opposition to a counter electrode opposed to said pedestal electrode within a plasma reaction chamber;
supplying an etching gas into said chamber; and
applying RF power between said electrodes so that between 5% and 35% of said RF power is applied to said counter electrode, a plasma of said etching gas being formed between said electrodes.

2. The process of Claim 1 wherein the effective surfaces areas of said electrodes exposed to said plasma differ by no more than 25%.

3. The process of Claim 1 or Claim 2, further comprising inductively coupling RF energy into said chamber to support said plasma.

4. The process of any of Claims 1 to 3, wherein said chamber comprises a conical dome intermediate said two electrodes around which is wrapped an inductive coil and further comprising inductively coupling RF energy into said chamber through said inductive coil.

5. The process of any of Claims 1 to 4,

wherein said substrate comprises a surface portion comprising an oxide or a nitride or a combination thereof of silicon and an underlying portion substantially of silicon, and
wherein said etching gas comprises a fluorine-containing gas and wherein said counter-electrode comprises a material that scavenges fluorine from said plasma.

7. The process of Claim 6, wherein said fluorine-containing gas is a fluorocarbon.

8. The process of Claim 7, wherein said etching gas additionally comprises a hydrofluorocarbon.

9. The process of Claim 6, wherein said counter-electrode comprises silicon.

10. The process of Claim 9, wherein said fluorine-containing gas comprises a fluorocarbon.

11. The process of Claim 10, wherein said etching gas additionally comprises a hydrofluorocarbon.

12. A process for etching in a plasma reactor chamber including an induction coil about said chamber, a pedestal electrode for supporting a substrate to be processed, and a counter electrode comprising a fluorine-scavenging material in parallel opposition to said pedestal electrode, said process comprising the steps of:

flowing an etching gas comprising carbon and fluorine into said chamber;
applying RF power to said induction coil;
applying a first amount of RF power to said pedestal electrode; and
applying a second amount of RF power less than said first amount of RF power to said counter-electrode, a plasma of said etching gas being formed in said chamber.

13. The process of Claim 12, further comprising maintaining a temperature of said counter electrode at less than 220°C.

14. The process of Claim 13, wherein said temperature of said counter electrode is maintained at less than 200°C.

15. The process of Claim 12, wherein said fluorine-scavenging material comprises silicon.

16. The process of Claim 15, further comprising maintaining a temperature of said counter electrode at less than 220°C.

17. The process of Claim 16, wherein said temperature of said counter electrode is maintained at less than 200°C.

18. The process of Claim 17, wherein all parts exposed to an interior of said chamber are maintained at temperatures of less than 200°C.

19. The process of Claim 17, wherein said temperature of said counter electrode is maintained at 180°C or greater but less than 200°C.

20. The process of Claim 19, wherein said applying steps cause said second and first amounts of RF power applied to said counter electrode and said pedestal to be in a finite power splitting ratio of less than 25%.

**21.** The process of Claim 20, wherein said power splitting ratio is at least 10%.

**22.** The process of Claim 18, wherein said etching gas comprises a fluorocarbon.

**23.** The process of Claim 22, wherein said etching gas additionally comprises a hydrofluorocarbon.

**24.** The process of Claim 12, wherein said steps of applying said first and second amounts of RF power includes splitting power between said pedestal electrode and said counter electrode from a common RF source.

**FIG._1**
(PRIOR ART)

**FIG._5**

**FIG._2**

EP 0 871 200 A2

*FIG._3*

*FIG._4*